# EUROPEAN PATENT SPECIFICATION

(11) **EP 2 714 590 B1**
(45) Date of publication and mention of the grant of the patent: **18.03.2015**
(21) Application number: 12723643.8
(22) Date of filing: 22.05.2012
(51) Int. Cl.: C01B 33/18, C01B 33/04, C01B 33/40

(54) **INSTALLATION AND METHOD FOR THE FUNCTIONALIZATION OF PARTICULATE AND POWDERED PRODUCTS**
ANLAGE UND VERFAHREN ZUR FUNKTIONALISIERUNG VON PARTIKELFÖRMIGEN UND PULVERFÖRMIGEN PRODUKTEN
INSTALLATION ET PROCÉDÉ POUR LA FONCTIONNALISATION DE PRODUITS PARTICULAIRES ET PULVÉRULENTS

(30) Priority: 23.05.2011 EP 11167044
(43) Date of publication of application: 09.04.2014
(73) Proprietor: Nanocyl S.A., 5060 Sambreville (BE)
(72) Inventor: LUIZI, Frédéric, 5020 MALONNE (BE); MINEA, Tiberiu Marian, 75016 PARIS (FR); LUCAS, Stéphane, 5380 FORVILLE (BE); AMADOU, Julien, 5640 SAINT GERARD (BE); USOLTSEVA, Anna, 5000 NAMUR (BE); RIGAUX, Christophe, 5100 JAMBES (BE)
(74) Representative: Pronovem
(86) International application number: PCT/EP2012/059437
(87) International publication number: WO 2012/160041

(56) References cited:
- DE-A1-102009 005 053
- FELTEN A ET AL: "Radio-frequency plasma functionalization of carbon nanotubes surface O2, NH3, and CF4 treatments", JOURNAL OF APPLIED PHYSICS, AMERICAN INSTITUTE OF PHYSICS. NEW YORK, US, vol. 98, no. 7, 7 October 2005 (2005-10-07), pages 74308-074308, XP012078724, ISSN: 0021-8979, DOI: 10.1063/1.2071455
- NASEH M V ET AL: "Fast and clean functionalization of carbon nanotubes by dielectric barrier discharge plasma in air compared to acid treatment", CARBON, ELSEVIER, OXFORD, GB, vol. 48, no. 5, 1 April 2010 (2010-04-01), pages 1369-1379, XP026893505, ISSN: 0008-6223, DOI: 10.1016/J.CARBON.2009.12.027 [retrieved on 2009-12-16]
- UTEGULOV ZHANDOS ET AL: "Functionalization of single-walled carbon nanotubes using isotropic plasma treatment: Resonant Raman spectroscopy study", JOURNAL OF APPLIED PHYSICS, AMERICAN INSTITUTE OF PHYSICS. NEW YORK, US, vol. 97, no. 10, 10 May 2005 (2005-05-10), pages 104324-104324, XP012069425, ISSN: 0021-8979

## Description

### Field of the invention

The present invention is related to a method for the functionalization of particulate and powdered products such as for example carbon black, glass fibres, carbon fibres and in particular carbon nanotubes. The present invention is also related to a plasma reactor able to functionalize these products.

### State of the art

Particulate and powdered substrates are often used as additives for reinforced polymer-based composites. In particular fibres, powders and nanoparticles are able to improve the physical properties of polymer-based composites.

Among the variety of particles, carbon nanotubes (CNTs) are particularly promising due to their unique mechanical and physical properties. However, the use of carbon nanotubes in polymer-based composites is now still limited due to the nonreactive nature of their surface and the agglomeration of CNTs into micron-size structures (as bundles, spheres etc.) during their growth. To overcome these problems, a functionalization (modification) of CNTs by changing their surface composition via the introduction of other elements or groups of elements (functional groups) has proved to be efficient.

Functionalization of carbon nanotubes can improve their solubility and processability and will allow to combine the unique properties of the carbon nanotubes with those of other types of materials. New chemical bonds created during the functionalization process might be used to tailor the interaction of the nanotubes with solvents or polymer matrices.

Functionalization of carbon nanotubes usually begins with the introduction of O-containing groups (mainly carboxylic groups), which further gives an access to a large number of functional exploitations by transformation of the carboxylic functions and provides anchor groups for further modification.

The introduction of O-containing groups in the structure of the CNTs can be realized via liquid-phase and gas-phase methods.

Liquid-phase oxidative treatment of carbon nanotubes is usually performed using boiling nitric acid, sulfuric acid, or a mixture of both. A so-called "piranha" solution (sulfuric acid-hydrogen peroxide mixture) can also be used. These methods have a low efficiency of functionalization, create defects in the structure of the CNTs, decrease their length, dramatically increase the density of the material and produce considerable amounts of toxic acidic waste.

Gas-phase oxidative processes are based on the treatment of the carbon nanotubes with oxygen, ozone or air at elevated temperatures. The main disadvantages of this type of functionalization are high-process temperatures leading to the creation of defects in the nanotube structure. Furthermore, this type of process requests a preliminary purification to remove the traces of metal catalysts which can catalyze the reaction of CNTs with O₂ or O₃.

Gas-phase functionalization can also be realized by using mechano-chemical treatment via ball milling of nanotubes under different reactive atmospheres such as H₂O, NH₃ and/or Cl₂. Nevertheless mechano-chemical functionalization also results in the considerable densification of CNTs and the formation of structural defects.

In contradistinction to the methods mentioned above, the functionalization method based on plasma treatment is a low-temperature process which is very effective, non-polluting and which can provide a wide range of functional groups. Thus, for industrial applications a plasma functionalization process should be preferred to other methods mentioned previously.

A plasma is a partially or entirely ionized gas or vapour comprising elements in various excitation states. This includes all molecules which are not in a fundamental state. Such plasma can be created and maintained by electromagnetic fields. Due to the exposure of the electromagnetic field, active species of plasma such as ions and free radicals are formed by collisions between molecules from the gas phase and free electrons. The resulting plasma consists of ions, free electrons, free radicals, species in an excited state, photons and neutral stable species. Free radicals react with the surface of treated materials differently depending on the gas nature and the surface chemistry of the material.

Depending on gas pressure, the plasma can be atmospheric or low-pressure. The pressure range below approximately 10³ Pa is designated as low-pressure plasma. One of the most important advantages of low-pressure plasma is that reactions requiring elevated temperatures at atmospheric pressure typically take place near ambient temperature under low-pressure plasma conditions. This phenomenon is due to the fact that despite low gas temperatures, high electron temperatures are realized in low-pressure plasma due to the increased free path length. Another advantage of low-pressure plasma is that treatment occurs under vacuum, i.e. in a precisely controlled environment. Due to this fact, the low-pressure plasma treatment has higher repeatability in comparison with atmospheric plasma process. Due to these advantages, low-pressure plasmas have found wide applications in materials processing (M. A. Lieberman, A. J. "Principles of plasma discharges and materials processing", New York, Wiley, 1994). Low-pressure plasma can be formed by applying a direct current (DC), low frequency (50Hz), radio frequency (RF) (40 kHz, 13.56 MHz) or microwave (GHz) electric field over a pair or a series of electrodes.

Radio frequency (RF) plasma devices generally use 13.56 MHz electromagnetic waves since this frequency band is dedicated to the research and does not affect telecommunications.

Plasma treatments can be achieved under various gas pressures in various reactors. In case of powders such as carbon black, graphite or carbon nanotubes, a uniform treatment of each particle is desirable but difficult to obtain. This is mainly due to particle size distributions and to the agglomeration of the particles.

In the prior art, vibrating and fluidized-bed reactors have been developed to functionalize carbon nanotubes (CNTs) with O-containing groups via plasma treatment by using high frequency electric fields. The disadvantage of a fluidized-bed reactor working continuously lies in the fact that the residence time of each particle treated in the reactor is in fact unknown and uncontrollable.

The document WO 2010/081747A discloses a fluidized-bed reactor of a particular shape, comprising a section enlargement in the reactor, where the plasma treatment of the powder occurs.

Felten et al. (Radio-frequency plasma functionalization of carbon nanotubes O2, NH3, and CF4 treatments, Journal of Applied Physics, vol. 98 (2005), pages 74308-1 to 74308-9), discloses an horizontal reactor in which the nanotube powder attached to a Scotch tape in introduced for plasma treatment.

Naseh et al. (Fast and clean functionalization of carbon nanotubes by dielectric barrier discharge plasma in air compared to acid treatment, Carbon, vol. 98 (2010), pages 1369-1379), is related to fixed bed reactors in which carbon nanotubes are annealed for dielectric barrier discharge plasma treatment.

Utegulov et al. (Functionalization of single-walled carbon nanotubes using isotropic plasma treatment: resonant Raman spectroscopy study, Journal of Applied Physics, vol. 97 (2005), pages 104324-1 to 104324-4), discloses stirred reactors in which the powder of carbon nanotubes are introduced from the bottom.

### Aims of the invention

The present invention aims to provide a plasma reactor and a method which does not have the drawbacks of the prior art.

The present invention aims in particular to propose a method allowing the powder to fall by gravity through the reaction zone containing active species created by the plasma at low pressure, which guarantees a specific residence time and a controlled treatment.

### Summary of the invention

The present invention discloses a continuous method for the functionalization of a pulverulent product in a plasma reactor comprising the steps of:
- generating a plasma in a vertical reactor;
- bringing the particles in contact with said plasma by letting said particles fall by gravity from top to bottom trough said reactor.

Preferred embodiments of the present invention disclose at least one or an appropriate combination of the following features:
- the continuous method comprises the steps of introducing said pulverulent product into the plasma reactor via an inlet lock chamber and recovering a functionalized pulverulent product in an outlet lock chamber without discontinuation of any of the steps;
- the pulverulent product comprises carbon nanotubes;
- the pressure of the plasma is lower than 10 Pa, preferably lower than 1 Pa, and most preferably lower than 0.8 Pa;
- the molecules for the generation of the plasma are introduced on the top of the plasma reactor;
- the vertical reactor has a constant cross section;
- the plasma is generated by a frequency of 13.56 MHz and a power between 100 and 1000 Watt, preferably between 200 and 600 Watt;
- contemplated molecules for the generation of the plasma are argon (Ar), helium (He), nitrogen (N₂), oxygen (O₂), hydrogen (H₂), water (H₂O), ammonia (NH₃), tetrafluoromethane (CF₄), allylamine (C₃H₅NH₂), acrylic acid (C₃H₄O₂), isoprene (C₅H₈), hexamethyldisiloxane (C₆H₁₈OSi₂), isoprene (C₅H₈), methanol (CH₃OH) and ethanol (C₂H₅OH), and in particular the molecules are selected from the groups consisting of inert gases such as argon (Ar), helium (He); nitrogen-containing gases such as molecular nitrogen (N₂), ammonia (NH₃); oxygen-containing gases such as oxygen (O₂), ozone (O₃), carbon monoxide (CO), carbon dioxide (CO₂); alkanes such as, for example, ethane (C₂H₆), hexane (C₆H₁₄); alkenes such as, for example, ethylene (C₂H₄); alkynes such as, for example, acetylene (C₂H₂); monomers such as, for example, methyl methacrylate (C₅H₈O₂); carboxylic acids with the formula R-COOH, where R is some monovalent functional group and R can be saturated, for example propanoic acid (C₃H₆O₂), or unsaturated, for example acrylic acid (C₃H₄O₂); amines such as alkylamines, for example methylamine (CH₅N), heptylamine (C₇H₁₇N), butylamine (C₄H₁₁N), propylamine (C₃H₉N), 1,3-diaminopropane or allylamines such as allylamine (C₃H₇N); amides such as, for example, dimethylformamide (C₃H₇NO), alcohols such as methanol (CH₃OH), ethanol (C₂H₅OH), allyl alcohol (C₃H₅OH), isopropyl alcohol (C₃H₇OH), 1-propanol (C₃H₇OH), propargyl alcohol (C₃H₃OH), furfuryl alcohol (C₅H₅O₂H), isobutanol (C₄H₉OH); silanes and their derivatives; siloxanes and their derivatives such as hexamethyldisiloxane (C₆H₁₈OSi₂); halogens and their derivatives, such as fluorocarbons, for example as tetrafluoromethane (CF₄); terpenes and terpenoids such as isoprene (C₅H₈) and its derivatives.

The present invention further discloses an installation for the functionalization of a pulverulent product by means of the method according to the invention comprising:
- a plasma reactor placed in a vertical position;
- a first device in connection with the reactor for admitting a gaseous precursor of active species into the reactor;
- a second device in connection with the plasma reactor for charging the reactor with a pulverulent product;
- a third device in connection with the plasma reactor for withdrawing the pulverulent product from the reactor wherein the second device and the third device include one or more lock chamber(s) isolated by one or more valve(s) from the plasma reactor;
- a fourth device surrounding at least a part of the reactor supplying electromagnetic waves for the generation of the plasma;
- a fifth device in connection with the plasma reactor for the generation of low-pressure in the plasma reactor.

Preferred embodiments of the installation according to the invention disclose at least one or an appropriate combination of the following features:
- the second device includes a distributor of the pulverulent product;
- the fourth device is an antenna, preferably solenoid coil-shaped;
- the second device includes a hopper in connection with a lock chamber;
- the first device comprises a flow mass controller.

### Short description of the drawings

Figure 1 represents the scheme of the plasma functionalization setup of the present invention.
Figure 2 represents the TEM images of the structure of pristine CNTs (A) and CNTs after plasma treatment under O₂ (**B**) and allylamine (**C**) atmosphere.
Figure 3 represents typical X-ray photoelectron spectra of CNTs before (**A**) and after (**B**) functionalization under N₂ atmosphere with the characteristic peaks of C, N and O.
Figure 4 represents the influence of power of Radio Frequency Electro-Magnetic (RF EM) field on the concentration of nitrogen attached on the CNTs surface after plasma treatment under N₂ atmosphere (based on XPS measurements).
Figure 5 represents the influence of the number of passages through the plasma on nitrogen and oxygen concentration in the CNTs after N₂ plasma treatment (based on XPS measurements).
Figure 6 represents the influence of the number of the antenna's coils on nitrogen concentration in the CNTs after plasma treatment under N₂ atmosphere (based on XPS measurements).
Figure 7 presents typical scanning electron microscopy images of non-carbon materials tested in plasma functionalization setup of the present invention: ferrite (A, B), fumed silica (C, D), silicate glass (E, F), cloisite (G, H).

### Detailed description of the invention

A large-scale method for the functionalization of powders, and in particular carbon nanotubes, together with a specific reactor type was developed.

The method is based on the treatment of the powders under plasma conditions and in particular under radio frequency (RF) plasma conditions in the presence of different gases.

Depending on the nature of the gas used, this method results in the particular case of carbon nanotubes in the replacement of a part of carbon atoms by other atoms or groups of atoms, and/or in the attachment of other atoms or groups of atoms to the carbon atoms of CNTs, or in the deposition of a layer of various substances on the surface of CNTs.

The variation of the process conditions allows to vary the nature and the concentration of elements or compounds introduced in or deposited on the structure of the CNT surface or other powders.
The main advantages of the method according to the invention are:
- cold surface treatment (there is no heating of the setup and the pulverulent product);
- possibility to vary the nature and the concentration of the elements introduced;
- high yield of the process in comparison with other existing methods of functionalization;

### Setup description

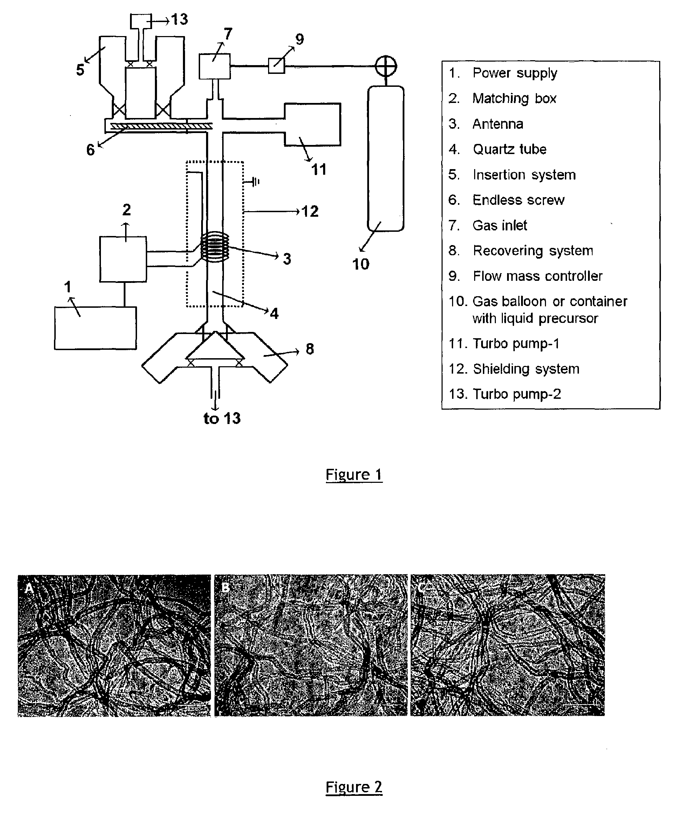

Figure 1 presents the scheme of setup for the plasma functionalization. The developed setup consists in a RF power supply 1 with a matching box 2 which is connected with an antenna 3. The antenna has several solenoid coils and is placed around a vertical quartz reactor 4. The expression "vertical reactor" or "vertical position" should be understood as "substantially vertical", comprising positions slightly deviating from a right angle of 90°.

The reactor is connected at the top with a powder insertion (feeding) system 5 with feeding means, for example an endless screw 6 and a gas inlet 7, and at the bottom with a product recovering system 8. The gas line consists in a gas inlet system 7, a flow mass controller 9 and a gas balloon (in the case of gaseous precursors) or container with a liquid (in the case of precursor in liquid state) 10. In a particular embodiment, both the gas inlet and the pumping system are situated on the top of the reactor.

The pressure inside the vertical reactor is controlled by one or more turbo pumping system(s) (11, 13) and a shielding system 12 avoids the propagation of electromagnetic waves outside the reactor zone.

The treated powder is delivered from the insertion system on the top of the reactor by a suitable feeding system, for example an endless screw, and is transferred through the reactor where it is submitted to the plasma treatment while falling by gravity forces to the bottom of the reactor where it is collected.

Since the reactor operates under specific low pressure conditions, the (vacuum) outlet 8 and the inlet 5 lock chambers are necessary for the introduction and the recovery of the plasma treated powders to maintain a low pressure inside the reactor. Double lock chambers in a parallel position (5, 8) such as represented in Figure 1 are preferred configurations allowing a continuous functionalization process without interruption of the powder supply and recovery.

### Operating conditions

The RF plasma is generated by a frequency of 13.56 MHz and the available power ranges between 100 - 1000 W. The process gas pressure in the reactor during the treatment is in the range of 10⁻² and 10 Pa.

The functionalization can be performed in presence of various substances, for example inert gases such as argon (Ar), helium (He); nitrogen-containing gases such as molecular nitrogen (N₂), ammonia (NH₃); oxygen-containing gases such as oxygen (O₂), ozone (O₃), carbon monoxide (CO), carbon dioxide (CO₂); alkanes such as, for example, ethane (C₂H₆), hexane (C₆H₁₄); alkenes such as, for example, ethylene (C₂H₄); alkynes such as, for example, acetylene (C₂H2); monomers such as, for example, methyl methacrylate (C₅H₈O₂); carboxylic acids with the formula R-COOH, where R is some monovalent functional group and R can be saturated, for example propanoic acid (C₃H₆O₂), or unsaturated, for example acrylic acid (C₃H₄O₂); amines such as alkylamines, for example methylamine (CH₅N), heptylamine (C₇H₁₇N), butylamine (C₄H₁₁N), propylamine (C₃H₉N), 1,3-diaminopropane or allylamines such as allylamine (C₃H₇N); amides such as, for example dimethylformamide (C₃H₇NO); alcohols such as methanol (CH₃OH), ethanol (C₂H₅OH), allyl alcohol (C₃H₅OH), isopropyl alcohol (C₃H₇OH), 1-propanol (C₃H₇OH), propargyl alcohol (C₃H₃OH), furfuryl alcohol (C₅H₅O₂H), isobutanol (C₄H₉OH); silanes and their derivatives; siloxanes and their derivatives such as hexamethyldisiloxane (C6H18OSi2); halogens and their derivatives, such as fluorocarbons, for example as tetrafluoromethane (CF4), terpenes and terpenoids such as isoprene (C5H8) and its derivatives.

The method and the installation are suitable for any pulverulent material. Non-limitative examples of powders submitted to functionalization can be single-wall (SWCNTs) or multi-wall carbon nanotubes (MWCNTs), carbon fibres, carbon black, graphite, glass fibres, metal oxides ex: ferrite, fumed silica, silicate glass, nanoclays.

### Characterization methods

The structure of the particles after functionalization was characterized by transmission electron microscopy (TEM). The concentration of inserted elements has been estimated by X-ray photoelectron spectroscopy (XPS).

In the particular case of carbon nanotubes, unique electrical and mechanical properties of polymer-based composites containing these nanotubes are obtained via the structure and the morphology of their aggregates. The preservation of the structure of CNTs and their aggregates during functionalization is therefore one of the important tasks. The structure of CNTs before and after plasma functionalization was investigated with TEM. Typical TEM images of pristine and plasma treated nanotubes presented in figure 2 demonstrate that the plasma functionalization process does not change the structure of the nanotubes, acting mainly on the extreme surface of CNTs.

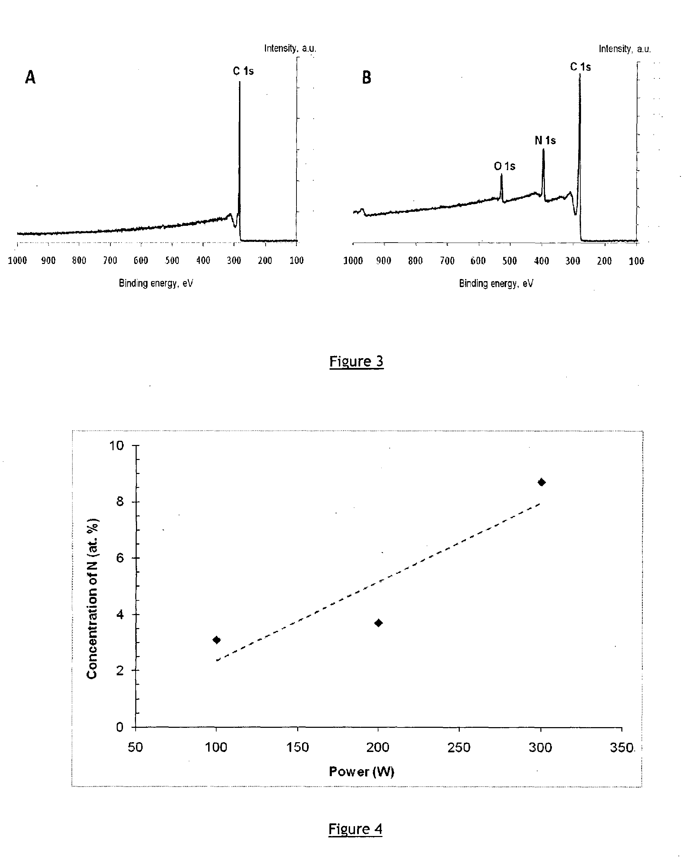

XPS spectra of CNTs after plasma functionalization proved the introduction/attachment of the elements (0 or/and N) in the nanotubes. The estimation of atomic concentrations of carbon and introduced elements is based on the measurements of the area of their characteristic peaks. The changes in typical XPS spectra of CNTs after functionalization are presented in figure 3.

The nature of the elements introduced during plasma functionalization can vary by using different gases. The concentration of elements can vary by changing the following parameters:
- RF power;
- length of the antenna (amount of solenoid loops or distance between them);
- process gas pressure;
- number of passages of the material through the plasma.

The results presented in figure 4 demonstrate that the increase of the power from 100 up to 300 watt results in the increase of nitrogen concentration in CNTs from 3 to 9 atomic %.

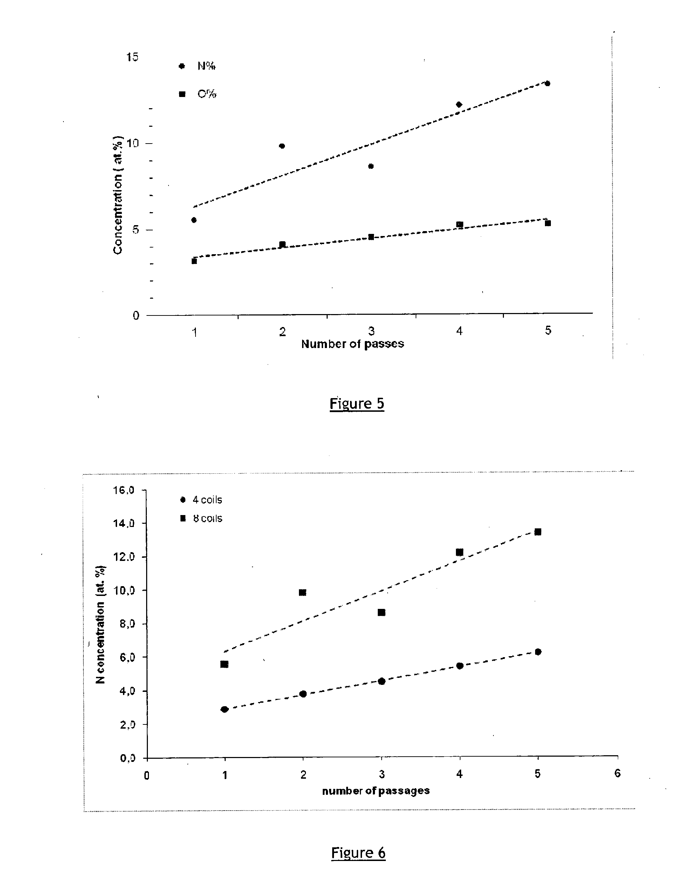

The increase of the number of passages through the plasma zone also results in the increase of the concentration of the introduced elements (fig. 5). A bigger concentration of introduced elements can also be achieved by increasing the number of solenoid loops in the antenna (fig. 6). So, the increase of the number of coils from 4 to 8 leads to the approximately twofold increase of nitrogen concentration.

### Examples:

### Example 1:

5.0 g of multi-wall carbon nanotubes were placed in the reservoir of the insertion system via an inlet lock chamber, the system was hermetically closed and the setup was pumped by a turbo pump up to a pressure of 5·10⁻³ Pa. An N₂ gas was inserted into the system via the top of the vertical reactor tube with a pressure of about 0.99 Pa. The RF plasma was generated by a frequency of 13.56 MHz with a power of 300 W and an antenna with 4 solenoid coils on a quartz reactor. CNTs were transferred from the reservoir to the center of the reactor on the top using the insertion system with an endless screw with the speed 0.4 rotation/sec approximately. CNTs passed through the plasma zone driven by the gravity force.

After passing the plasma zone, CNTs were collected in the recovery system tank via an outlet lock chamber. The whole system is arranged to coordinate the closure and the opening of the lock chambers so that the low pressure can be maintained while a continuous supply and recovery of CNTs is possible. The concentration of N, O and C was estimated by XPS method. The structure of CNTs was investigated by transmission electron microscopy. The composition of the CNTs sample after functionalization is the following: 93.7 at.% of C, 2.9 at.% of N, 3.4 at.% of O. The composition of the CNTs sample before functionalization was: 99.1 at.% of C, 0.9 at.% of O.

### Example 2:

The same operating conditions as in Example 1 were chosen, but an NH₃ gas was used instead of N₂, with the same pressure (0.99 Pa). The composition of CNT sample after functionalization based on XPS measurements was the following: 96.8 at.% of C, 1.0 at.% of N, 2.2 at.% of 0.

### Example 3:

The same operating conditions as in Example 1 were chosen, but an C₃H₅NH₂ gas was used instead of N₂, with the same pressure (0.99 Pa). The composition of CNT sample after functionalization based on XPS measurements was the following: 95.7 at.% of C, 1.8 at.% of N, 2.5 at.% of 0.

### Example 4:

The same operating conditions as in Example 1 were chosen, but an H₂ gas was used instead of N₂, with the same pressure (0.99 Pa). The composition of CNT sample after functionalization based on XPS measurements was the following: 98.5 at.% of C, and 1.5 at.% of 0.

### Example 5:

The same operating conditions as in Example 1 were chosen, but an H₂O gas was used instead of N₂, with the same pressure (0.99 Pa). The composition of the CNT sample after functionalization based on XPS measurements was the following: 97.2 at.% of C, and 2.8 at.% of 0.

### Example 6:

The same operating conditions as in Example 1 were chosen, but an O₂ gas was used instead of N₂, with the same pressure (0.99 Pa). The composition of the CNT sample after functionalization based on XPS measurements was the following: 96.5 at.% of C, and 3.5 at% of 0.

### Example 7:

The same operating conditions as in Example 1 were chosen, but a C₃H₄O₂ gas was used instead of N₂, with the same pressure (0.99 Pa). The composition of the CNT sample after functionalization based on XPS measurements was the following: 97.6 at.% of C, and 2.4 at.% of 0.

### Example 8:

The same operating conditions as in Example 1 were chosen, but the sample was passed through the plasma zone 5 times instead of one. The composition of the CNT sample after functionalization based on XPS measurements was the following: 87.4 at.% of C, 6.2 at.% of N, 6.4 at.% of 0.

### Example 9:

The same operating conditions as in Example 1 were chosen, but the antenna with 8 solenoid coils was used instead of a 4-coils antenna. The composition of the CNT sample after functionalization based on XPS measurements was the following: 91.2 at.% of C, 5.6 at.% of N, 3.2 at.% of 0.

### Example 10:

The same operating conditions as in Example 1 were chosen, but the antenna with 8 solenoid coils was used instead of a 4-coils antenna and the sample was passed through the plasma zone 5 times instead of one. The composition of the CNT sample after functionalization based on XPS measurements was the following: 81.3 at.% of C, 13.4 at.% of N, 5.3 at.% of 0.

### Example 11:

The same operating conditions as in Example 1 were chosen, but the power of 100 W was used instead of 300 W. The composition of the CNT sample after functionalization based on XPS measurements was the following: 94.7 at.% of C, 1.2 at.% of N, 4.1 at.% of O.

### Example 12:

The same operating conditions as in Example 1 were chosen, but the power of 200 W was used instead of 300 W. The composition of the CNT sample after functionalization based on XPS measurements was the following: 89.8 at.% of C, 5.9 at. % of N, 4.3 at.% of O.

### Example 13:

The same operating conditions as in Example 1 were chosen, but the N₂ pressure of 0.48 Pa was used instead of 0.99 Pa. The composition of the CNT sample after functionalization based on XPS measurements was the following: 88.1 at.% of C, 8.7 at.% of N, 3.2 at.% of O.

### Example 14:

The same operating conditions as in Example 1 were chosen, but the N₂ pressure of 0.48 Pa was used instead of 0.99 Pa and the power of 100 W was used instead of 300 W. The composition of the CNT sample after functionalization based on XPS measurements was the following: 93.5 at.% of C, 3.1 at.% of N, 3.4 at.% of O.

### Example 15:

The same operating conditions as in Example 1 were chosen, but the N₂ pressure of 0.48 Pa was used instead of 0.99 Pa and the power of 200 W was used instead of 300 W. The composition of the CNT sample after functionalization based on XPS measurements was the following: 93.7 at.% of C, 3.7 at.% of N, 2.6 at.% of O.

### Example 16:

The same operating conditions as in Example 1 were chosen, but 5.0 g of carbon black (KETJENBLACK EC600JD, AKZO NOBEL) were used instead of multi-wall carbon nanotubes. The composition of the sample after functionalization based on XPS measurements was the following: 93.5 at.% of C, 4.1 at.% of N, 2.4 at.% of 0. The composition of the sample before the plasma treatment was: 97.4 at.% of C, 2.6 at.% of 0.

### Example 17:

The same operating conditions as in Example 1 were chosen, but 5.0 g of graphite (Expandable graphite GHL PX 98, HUNTSMAN) were used instead of multi-wall carbon nanotubes. The composition of the sample after functionalization based on XPS measurements was the following: 95.2 at.% of C, 1.6 at.% of N, 3.2 at.% of 0. The composition of the sample before the treatment was: 99.1 at.% of C, 0.9 at.% of 0.

### Example 18:

The same operating conditions as in Example 1 were chosen, but 5.0 g of glass fibers were used instead of multi-wall carbon nanotubes. The composition of the sample after functionalization based on XPS measurements was the following: 44.2 at.% of C, 16.1 at.% of N, 39.7 at.% of 0. The composition of the sample before the treatment was: 73.4 at.% of C, 26.6 at.% of 0. No presence of Si was detected because of the presence of polymer sizing on the surface of glass fibers.

### Example 19:

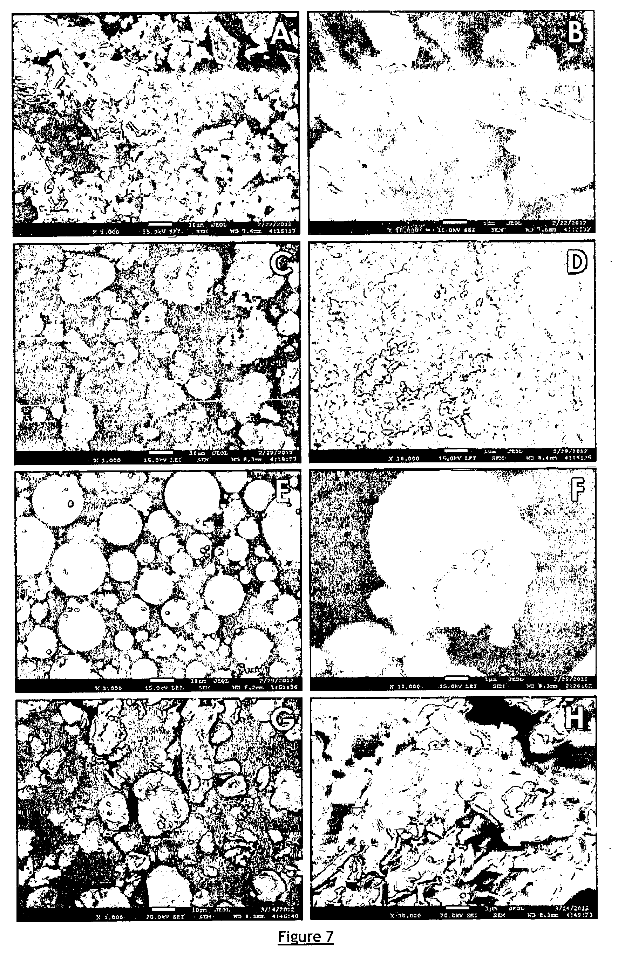

The same operating conditions as in Example 1 were chosen, but 5.0 g of ferrite powder (Fe₂O₃), consisting of irregular shape particles with size 0.2 -50 µm (figure 7A, B), were used instead of multi-wall carbon nanotubes, the antenna with 8 solenoid coils was used instead of a 4-coils antenna, the N₂ pressure of 2.0 Pa was used instead of 0.99 Pa and the sample was passed through the plasma zone 5 times instead of one. The composition of the sample after functionalization based on XPS measurements was the following: 2.9 at.% of N, 67.4 at.% of 0, 29.7 at.% of Fe. The composition of the sample before the treatment was: 69.1 at.% of 0, 30.9 at.% of Fe.

### Example 20:

The same operating conditions as in Example 1 were chosen, but 5.0 g of fumed silica powder (SiO₂), consisting of agglomerates with size 1-20 µm of particles with size < 100nm (figure 7C, D), were used instead of multi-wall carbon nanotubes, the antenna with 8 solenoid coils was used instead of a 4-coils antenna, C₃H₅NH₂ was used instead of N₂ with the pressure of 2.0 Pa, and the sample was passed through the plasma zone 5 times instead of one. The composition of the sample after functionalization based on XPS measurements was the following: 1.9 at.% of N, 65.7 at.% of 0, 32.4 at.% of Si. The composition of the sample before the treatment was: 67.1 at.% of 0, 32.9 at.% of Si.

### Example 21:

The same operating conditions as in Example 1 were chosen, but 5.0 g of silicate glass powder (with approximate formula Na₂O·CaO·6SiO₂), consisting of spherical particles with size 0.1 - 50 µm (figure 7E, F), were used instead of multi-wall carbon nanotubes, the antenna with 8 solenoid coils was used instead of a 4-coils antenna, the N₂ pressure of 2.0 Pa was used instead of 0.99 Pa and the sample was passed through the plasma zone 5 times instead of one. The composition of the sample after functionalization based on XPS measurements was the following: 0.8 at.% of N, 62.2 at.% of 0, 25.5 at.% of Si, 9.9 at.% of Na, 1.6 at.% of Ca. The composition of the sample before the treatment was: 63.2 at.% of 0, 26.4 at.% of Si, 8.8 at.% of Na, 1.6 at.% of Ca.

### Example 22:

The same operating conditions as in Example 1 were chosen, but 5.0 g of silicate glass powder (with approximate formula Na₂O·CaO·6SiO₂) were used instead of multi-wall carbon nanotubes, the antenna with 8 solenoid coils was used instead of a 4-coils antenna, allylamine (C₃H₅NH₂) with pressure of 2.0 Pa were used instead of nitrogen and the sample was passed through the plasma zone 5 times instead of one. The composition of the sample after functionalization based on XPS measurements was the following: 12.1 at.% of N, 56.2 at.% of 0, 23.7 at.% of Si, 6.6 at.% of Na, 1.4 at.% of Ca. The composition of the sample before the treatment was: 63.2 at.% of 0, 26.4 at.% of Si, 8.8 at.% of Na, 1.6 at.% of Ca.

### Example 23:

The same operating conditions as in Example 1 were chosen, but 5.0 g of nanoclay Cloisite 20A powder (with approximate formula Mₓ(Al₄₋ₓMg)Si₈O₂₈(OH)₄, where M can be Na⁺, Ca²⁺ or NH₄⁺), consisting of irregular shape agglomerates of flakes-like particles with aggregates size 1 - 20 µm (figure 7H, G), were used instead of multi-wall carbon nanotubes, the antenna with 8 solenoid coils was used instead of a 4-coils antenna, N₂ pressure of 2.0 Pa was used instead of 0.99 Pa and the sample was passed through the plasma zone 5 times instead of one. The composition of the sample after functionalization based on XPS measurements was the following: 8.5 at.% of N, 56.8 at.% of 0, 21.8 at.% of Si, 9.5 at.% of Al, 3.4 at.% of Mg. The composition of the sample before the treatment was: 62.0 at.% of 0, 23.7 at.% of Si, 10.6 at.% of Al, 3.7 at.% of Mg.

Table 1 summarizes the correlation between the nature of the gas, the reaction parameters and the concentration of the elements which are introduced in the powder structure.

**Table 1. The relationship between the plasma treatment parameters and the nature and the concentration of the introduced elements**

| **Sample number** | **Type of powder** | **Gas** | **Pressure, [Pa]** | **Antenna (number of coils)** | **Power [W]** | **Number of passages** | **Element composition, [atomic %]** |
|---|---|---|---|---|---|---|---|
| 1 | MWCNT | - | - | - | - | - | 99.1 (C), 0.0 (N), 0.9 (O) |
| 1 | MWCNT | N₂ | 0.99 | 4 | 300 | 1 | 93.8 (C), 2.9 (N), 3.4 (O) |
| 2 | MWCNT | NH₃ | 0.99 | 4 | 300 | 1 | 96.8 (C), 1.0 (N), 2.2 (O) |
| 3 | MWCNT | C₃H₅NH₂ | 0.99 | 4 | 300 | 1 | 95.7 (C), 1.8 (N), 2.5 (N) |
| 4 | MWCNT | H₂ | 0.99 | 4 | 300 | 1 | 98.5 (C), 0.0 (N), 1.5 (0) |
| 5 | MWCNT | H₂O | 0.99 | 4 | 300 | 1 | 97.2 (C), 0.0 (N), 2.8 (O) |
| 6 | MWCNT | O₂ | 0.99 | 4 | 300 | 1 | 96.5 (C), 0.0 (N), 3.5 (O) |
| 7 | MWCNT | C₃H₄O₂ | 0.99 | 4 | 300 | 1 | 97.6 (C), 0.0 (N), 2.4 (O) |
| 8 | MWCNT | N₂ | 0.99 | 4 | 300 | 5 | 87.4 (C), 6.2 (N), 6.4 (O) |
| 9 | MWCNT | N₂ | 0.99 | 8 | 300 | 1 | 91.2 (C), 5.6 (N), 3.2 (O) |
| 10 | MWCNT | N₂ | 0.99 | 8 | 300 | 5 | 81.3 (C), 13.4 (N), 5.3 (O) |
| 11 | MWCNT | N₂ | 0.99 | 4 | 100 | 1 | 94.7 (C), 1.2 (N), 4.1 (O) |
| 12 | MWCNT | N₂ | 0.99 | 4 | 200 | 1 | 89.8 (C), 5.9 (N), 4.3 (O) |
| 13 | MWCNT | N₂ | 0.48 | 4 | 300 | 1 | 88.1 (C), 8.7 (N), 3.2 (O) |
| 14 | MWCNT | N₂ | 0.48 | 4 | 100 | 1 | 93.5 (C), 3.1 (N), 3.4 (O) |
| 15 | MWCNT | N₂ | 0.48 | 4 | 200 | 1 | 93.7 (C), 3.7 (N), 2.6 (O) |
| 16 | carbon black | - | - | - | - | - | 97.4 (C), 0.0 (N), 2.6 (O) |
| 16 | carbon black | N₂ | 0.99 | 4 | 300 | 1 | 93.5 (C), 4.1 (N), 2.4 (O) |
| 17 | graphite | - | - | - | - | - | 99.1 (C), 0.0 (N), 0.9 (O) |
| 17 | graphite | N₂ | 0.99 | 4 | 300 | 1 | 95.2 (C), 1.6 (N), 3.2 (O) |
| 18 | glass fibers | - | - | - | - | - | 73.4 (C), 0.0 (N), 26.6 (O) |
| 18 | glass fibers | N₂ | 0.99 | 4 | 300 | 1 | 44.2 (C), 16.1 (N), 39.7 (O) |
| 19 | ferrite | - | - | - | - | - | 0.0 (N), 69.1 (0), 30.9 (Fe) |
| 19 | ferrite | N₂ | 2.00 | 8 | 300 | 5 | 2.9 (N), 67.4 (0), 29.7 (Fe) |
| 20 | fumed silica | - | - | - | - | - | 0.0 (N), 67.1 (0), 32.9 (Si) |
| 20 | fumed silica | C₃H₅NH₂ | 2.00 | 8 | 300 | 5 | 1.9 (N), 65.7 (0), 32.4 (Si) |
| 21 | silicate glass | - | - | - | - | - | 0.0 (N), 63.2 (0), 26.4 (Si), 8.8 (Na), 1.6 (Ca) |
| 21 | silicate glass | N₂ | 2.00 | 8 | 300 | 5 | 0.8 (N), 62.2 (0), 25.5 (Si), 9.9 (Na), 1.6 (Ca) |
| 22 | silicate glass | C₃H₅NH₂ | 2.00 | 8 | 300 | 5 | 12.1 (N), 56.2 (O), 23.7 (Si), 6.6 (Na), 1.4 (Ca) |
| 23 | cloisite | - | - | - | - | - | 0.0 (N), 62.0 (0), 23.7 (Si) 10.6 (Al), 3.7 (Mg) |
| 23 | cloisite | N₂ | 2.00 | 8 | 300 | 5 | 8.5 (N), 56.8 (0), 21.8 (Si) 9.5 (Al), 3.4 (Mg) |

## Claims

1. A continuous method for the functionalization of a pulverulent product in a plasma reactor comprising the steps of:
- generating a plasma in a vertical reactor;
- bringing the pulverulent product in contact with said plasma by letting said particles fall by gravity from top to bottom trough said reactor.

2. The continuous method according to claim 1 comprising the steps of introducing said pulverulent product into the plasma reactor via an inlet lock chamber (5) and recovering a functionalized pulverulent product in an outlet lock chamber (8) without discontinuation of any of the steps.

3. The continuous method according to claim 1 or 2, wherein said pulverulent product comprises carbon nanotubes.

4. The continuous method according to any of the previous claims, wherein the pressure of the plasma is lower than 10 Pa, preferably lower than 1 Pa, and most preferably lower than 0.8 Pa.

5. The continuous method according to any of the previous claims, wherein the molecules for the generation of the plasma are introduced on the top of the plasma reactor.

6. The continuous method according to any of the previous claims, wherein the plasma is generated by a frequency of 13.56 MHz and a power between 100 and 1000 Watt, preferably between 200 and 600 Watt.

7. The continuous method according to any of the previous claims wherein the molecules for the generation of the plasma are selected from the group consisting of argon (Ar), helium (He), nitrogen (N2), oxygen (O2), hydrogen (H2), water (H2O), ammonia (NH3), allylamine (C3H5NH2), acrylic acid (C3H4O2), isoprene (C5H8), methanol (CH3OH) and ethanol (C2H5OH).

8. An installation for the functionalization of a pulverulent product by means of the method according to any of the claims 1 to 7 comprising:
- a plasma reactor placed in a vertical position;
- a first device in connection with the reactor for admitting a gaseous plasma precursor into the reactor;
- a second device in connection with the plasma reactor for charging the reactor with a pulverulent product;
- a third device in connection with the plasma reactor for withdrawing the pulverulent product from the reactor wherein the second device and the third device include one or more lock chamber(s) isolated by one or more valve(s) from the plasma reactor;
- a fourth device surrounding at least a part of the reactor supplying electromagnetic waves for the generation of the plasma;
- a fifth device in connection with the plasma reactor for the generation of low pressure in the plasma reactor.

9. The installation according to claim 8, wherein the second device includes a distributor of the pulverulent product.

10. The installation according to claim 8 or 9, wherein the fourth device is an antenna, preferably solenoid coil-shaped.

11. The installation according to any of the claims 8 to 10, wherein the second device includes a hopper in connection with a lock chamber.

12. The installation according to any of the claims 8 to 11, wherein the first device comprises a flow controller, preferably a flow mass controller.

## Patentansprüche

1. Kontinuierliches Verfahren zum Funktionalisieren eines pulverförmigen Produkts in einem Plasmareaktor, das die Schritte umfasst:
- Erzeugen eines Plasmas in einem vertikalen Reaktor;
- Inkontaktbringen des pulverförmigen Produkts mit dem Plasma, indem die Partikel durch die Schwerkraft von oben nach unten durch den Reaktor fallengelassen werden.

2. Kontinuierliches Verfahren nach Anspruch 1, das die Schritte des Einbringens des pulverförmigen Produkts in den Plasmareaktor über eine Einlassschleusenkammer (5) und des Gewinnens eines funktionalisierten pulverförmigen Produkts in einer Auslassschleusenkammer (8) ohne Aussetzung einer der Schritte umfasst.

3. Kontinuierliches Verfahren nach Anspruch 1 oder 2, wobei das pulverförmige Produkt Kohlenstoffnanoröhrchen umfasst.

4. Kontinuierliches Verfahren nach einem der vorstehenden Ansprüche, wobei der Druck des Plasmas geringer als 10 Pa, vorzugsweise geringer als 1 Pa und am meisten bevorzugt geringer als 0,8 Pa ist.

5. Kontinuierliches Verfahren nach einem der vorstehenden Ansprüche, wobei die Moleküle zum Erzeugen des Plasmas im obersten Bereich des Plasmareaktors eingebracht werden.

6. Kontinuierliches Verfahren nach einem der vorstehenden Ansprüche, wobei das Plasma durch eine Frequenz von 13,56 MHz und eine Leistung zwischen 100 und 1000 Watt, vorzugsweise zwischen 200 und 600 Watt, erzeugt wird.

7. Kontinuierliches Verfahren nach einem der vorstehenden Ansprüche, wobei die Moleküle für das Erzeugen des Plasmas aus der Gruppe ausgewählt sind, bestehend aus Argon (Ar), Helium (He), Stickstoff (N2), Sauerstoff (O2), Wasserstoff (H2), Wasser (H2O), Ammoniak (NH3), Allylamin (C3H5NH2), Acrylsäure (C3H4O2), Isopren (C5H8), Methanol (CH30H) und Ethanol (C2H5OH).

8. Einrichtung zum Funktionalisieren eines pulverförmigen Produkts mithilfe des Verfahrens nach einem der Ansprüche 1 bis 7, die umfasst:
- einen Plasmareaktor, der in einer vertikalen Position angeordnet ist;
- eine erste Vorrichtung in Verbindung mit dem Reaktor zum Einlassen eines gasförmigen Plasmavorläufers in den Reaktor;
- eine zweite Vorrichtung in Verbindung mit dem Plasmareaktor zum Beladen des Reaktors mit einem pulverförmigen Produkt;
- eine dritte Vorrichtung in Verbindung mit dem Plasmareaktor zum Entnehmen des pulverförmigen Produkts aus dem Reaktor, wobei die zweite Vorrichtung und die dritte Vorrichtung eine oder mehrere Schleusenkammern enthalten, die durch ein oder mehrere Ventile vom Plasmareaktor isoliert sind;
- eine vierte Vorrichtung, die zumindest einen Teil des Reaktors umgibt, die elektromagnetische Wellen zum Erzeugen des Plasmas zuführt;
- eine fünfte Vorrichtung in Verbindung mit dem Plasmareaktor zum Erzeugen eines niedrigen Drucks im Plasmareaktor.

9. Einrichtung nach Anspruch 8, wobei die zweite Vorrichtung einen Verteiler des pulverförmigen Produkts enthält.

10. Einrichtung nach Anspruch 8 oder 9, wobei die vierte Vorrichtung eine Antenne ist, die vorzugsweise magnetspulenförmig ist.

11. Einrichtung nach einem der Ansprüche 8 bis 10, wobei die zweite Vorrichtung einen Trichter in Verbindung mit einer Schleusenkammer enthält.

12. Einrichtung nach einem der Ansprüche 8 bis 11, wobei die erste Vorrichtung einen Durchflussregler umfasst, vorzugsweise einen Massendurchflussregler.

## Revendications

1. Procédé continu pour la fonctionnalisation d'un produit pulvérulent dans un réacteur à plasma, comprenant les étapes :
- générer un plasma dans un réacteur vertical ;
- porter le produit pulvérulent en contact avec ledit plasma en laissant lesdites particules tomber par gravité de haut en bas à travers ledit réacteur.

2. Procédé continu selon la revendication 1, comprenant les étapes consistant à introduire ledit produit pulvérulent dans le réacteur à plasma via un sas d'entrée (5) et à récupérer un produit pulvérulent fonctionnalisé dans un sas de sortie (8) sans interruption d'aucune des étapes.

3. Procédé continu selon la revendication 1 ou 2, dans lequel ledit produit pulvérulent comprend des nanotubes de carbone.

4. Procédé continu selon l'une quelconque des revendications précédentes, dans lequel la pression du plasma est inférieure à 10 Pa, de préférence inférieure à 1 Pa, et de manière particulièrement préférée inférieure à 0,8 Pa.

5. Procédé continu selon l'une quelconque des revendications précédentes, dans lequel les molécules pour la génération du plasma sont introduites par le haut du réacteur à plasma.

6. Procédé continu selon l'une quelconque des revendications précédentes, dans lequel le plasma est généré par une fréquence de 13,56 MHz et une puissance comprise entre 100 et 1000 watts, de préférence entre 200 et 600 watts.

7. Procédé continu selon l'une quelconque des revendications précédentes, dans lequel les molécules pour la génération du plasma sont choisies parmi le groupe constitué par l'argon (Ar), l'hélium (He), l'azote (N2), l'oxygène (O2), l'hydrogène (H2), l'eau (H2O), l'ammoniac (NH3), l'allylamine (C3H5NH2), l'acide acrylique (C3H4O2), l'isoprène (C5H8), le méthanol (CH3OH) et l'éthanol (C2H5OH).

8. Installation pour la fonctionnalisation d'un produit pulvérulent produit au moyen du procédé selon l'une quelconque des revendications 1 à 7, comprenant :
- un réacteur à plasma placé en position verticale ;
- un premier dispositif connecté au réacteur pour permettre l'introduction d'un précurseur de plasma gazeux dans le réacteur ;
- un deuxième dispositif connecté au réacteur à plasma pour charger le réacteur avec un produit pulvérulent;
- un troisième dispositif connecté au réacteur à plasma pour soutirer le produit pulvérulent hors du réacteur,
dans laquelle le deuxième dispositif et le troisième dispositif comprennent un ou plusieurs sas isolés du réacteur à plasma par une ou plusieurs valves ;
- un quatrième dispositif entourant au moins une partie du réacteur, fournissant des ondes électromagnétiques pour la génération du plasma,
- un cinquième dispositif connecté au réacteur à plasma pour générer une basse pression dans le réacteur à plasma.

9. Installation selon la revendication 8, dans laquelle le deuxième dispositif comprend un distributeur du produit pulvérulent.

10. Installation selon la revendication 8 ou 9, dans laquelle le quatrième dispositif est une antenne, de préférence en forme de bobine solénoïde.

11. Installation selon l'une quelconque des revendications 8 à 10, dans laquelle le deuxième dispositif comprend une trémie connectée à un sas.

12. Installation selon l'une quelconque des revendications 8 à 11, dans laquelle le premier dispositif comprend un régulateur de débit, de préférence un régulateur de débit massique.
